# EUROPÄISCHE PATENTSCHRIFT

(11) **EP 2 530 707 B1**
(45) Veröffentlichungstag und Bekanntmachung des Hinweises auf die Patenterteilung: **14.11.2018**
(21) Anmeldenummer: 12003853.4
(22) Anmeldetag: 16.05.2012
(51) Int. Cl.: H01L 21/48, H01L 23/14, H01L 23/373, C04B 37/02

(54) **Verfahren zur Herstellung eines Moduls und der Modul**
Method for making a module and the module
Procédé de préparation d'un module et le module

(30) Priorität: 31.05.2011 DE 102011103746
(43) Veröffentlichungstag der Anmeldung: 05.12.2012
(73) Patentinhaber: IXYS Semiconductor GmbH, D-68623 Lampertheim (DE)
(72) Erfinder: Knoll, Heiko, Dipl.-Ing., 35037 Marburg (DE)
(74) Vertreter: Oppermann, Frank

(56) Entgegenhaltungen:
- EP-A1- 1 450 401
- EP-A1- 2 006 895
- EP-A1- 2 447 235
- EP-A2- 0 726 239
- EP-A2- 1 187 198
- EP-A2- 1 187 198
- EP-A2- 1 298 108
- WO-A1-2010/092923
- JP-A- 2007 281 498
- US-A- 6 033 787

## Beschreibung

Die Erfindung betrifft ein Verfahren zur Herstellung eines Moduls. Die resultierenden Metall-Keramik-Module können insbesondere im Bereich von Leistungshalbleitermodulen als Schaltungsträger eingesetzt werden. Typischerweise handelt es sich bei diesen Schaltungsträgern um eine auf Ober- und Unterseite mit einer Metallisierung, wie z. B. Aluminium oder Kupfer, versehenen Keramik, beispielsweise einer Oxidkeramik, bei der mindestens eine metallisierte Seite eine schaltungstechnische Struktur aufweist. Die mit dem Keramik-Substrat zu fügenden Metallkörper dienen insbesondere dazu, die im leistungselektronischen Bauteil während des Betriebes entstehende Wärme weiter- oder abzuleiten.
Stand der Technik zum Befestigen von Keramik-Substraten an zur Wärmeabführung genutzten Metallkörpern, beispielsweise bei Modul-Bodenplatten, ist das stoffschlüssige Verbinden der Komponenten, z. B. durch Weichlöten mit SnPb-, SnAg-, SnAgCu- oder vergleichbaren geeigneten Lotmaterialien. Ein derartiges Verfahren wird beispielsweise in der Anmeldung US 2010068552 A1 beschreiben. Die verwendeten Metallkörper haben typischerweise eine Dicke zwischen 3 mm und 10 mm.
Allerdings führt das stoffschlüssige Verbinden von Keramik-Substraten und Bodenplatten, welche typischerweise aus Kupfer (Cu) bestehen, mittels Weichlot bei thermischer Wechselbelastung der Leistungsmodule zur Bildung von Rissen und Delaminationen in der Lotschicht, welche zum einen den Wärmetransfer vermindern und darüber hinaus zu einem Ausfall des Bauteils führen können. Die Anzahl der mechanischen Belastungszyklen bis zur Rissentstehung, beispielsweise verursacht durch Temperaturwechselbelastungen im Einsatz, ist dabei neben den Materialeigenschaften des Keramik-Substrats, der Bodenplatte und des Lotmaterials, wie z. B. den Wärmeausdehnungskoeffizienten und den E-Moduli, abhängig vom wirkenden Temperaturhub, der Lotdicke sowie der lateralen Substratgröße.
Auch die Verwendung von Hartlötmaterialien zum Verbinden von Keramik-Substraten mit Metallkörpern ist bereits bekannt.

Beispielsweise beschreibt die Anmeldung EP 0 827 198 A1 ein Verfahren zum Verbinden eines Keramik-Substrats mit einer Kupferplatte unter Verwendung eines Hartlötmaterials, das ein aktives Metall, wie Titan, Chrom oder Hafnium, enthält. Die einzelnen Teile werden verpresst und zur Bindung der Verbindung bei 850°C oder 1.063°C in einem Vakuumofen erhitzt.

Die Anmeldung EP 0 788 153 A2 offenbart ein Verfahren zum Verbinden eines Keramik-Substrats mit einer Metallschicht unter Verwendung eines Lötmittels mit einem Schmelzpunkt von höchstens 1.000°C, das im Wesentlichen aus Nickel, Kupfer und/oder Eisen besteht. Beispielhaft wird die Verwendung von NiP erwähnt, welches zunächst bei 600°C mit dem Keramik-Substrat verbunden und anschließend bei 970°C mit der Metallschicht verbunden wird. Die Dicke der resultierenden Lötmittelverbindungsschicht wird mit 2 µm bis 40 µm angegeben.

Die Anmeldung EP 0 969 511 A2 betrifft ebenfalls ein Verfahren zum Verbinden eines Keramik-Substrats mit einer Metallschicht, bei welchem man ein Lötmittel mit einem Schmelzpunkt von höchstens 1.000°C einsetzt, das im Wesentlichen aus Nickel, Kupfer und/oder Eisen besteht. Beispielhaft wird die Verwendung von NiP erwähnt, welches zunächst bei 600°C mit dem Keramik-Substrat verbunden und anschließend bei 970°C mit der Metallschicht verbunden wird.

Allerdings ist diese Vorgehensweise für die Befestigung von Keramik-Substraten, die mindestens auf einer Seite eine Metallisierung aufweisen, an zur Wärmeabführung genutzten Metallkörpern nicht geeignet, da bei thermischer Wechselbelastung der Leistungsmodule eine Bildung von Rissen und Delaminationen zu beobachten ist, welche zum einen den Wärmetransfer vermindern und darüber hinaus zu einem Ausfall des Bauteils führen können. Weiterhin ist diese Vorgehensweise, insbesondere aufgrund der vergleichsweise hohen Temperaturen, äußerst aufwendig und kostenintensiv.

Neben den Lötverfahren sind auch sogenannte Direct-Bonding-Verfahren, wie z. B. das Direct Copper Bonding (DCB), das Direct Aluminium Bonding (DAB) und das Active Metal Brazing (AMB), bekannt, bei welchen man das Metall bei hohen Temperaturen aufschmilzt, die resultierende Schmelze auf das Keramik-Substrat aufbringt und anschließend verfestigt. Solche Verfahren werden beispielsweise in den Anmeldungen EP 0 676 800 A2, EP 1 187 198 A2 und EP 2 214 202 A2 gezeigt, die Methoden zur Herstellung von Aluminium-metallisierten Keramik-Substraten sowie das Fügen solcher Substrate an Grundplatten aus Aluminium oder Aluminiumlegierungen beschreiben.

Die Anmeldung EP 1 187 198 A2 vergleicht weiterhin im experimentellen Teil die vorstehend beschriebene Vorgehensweise mit einem Verfahren, bei welchem man ein Aluminiumnitrid-Keramik-Substrat zunächst mit Lötmaterial bedruckt, das 87,5 Gew.-% Al und 12,5 Gew.-% Si enthält, und anschließend ein Aluminiumwalzblech auf dem Keramik-Substrat anordnet, den Verbund auf 575°C in einem Vakuumofen erhitzt und dann stromlos vernickelt (siehe EP 1 187 198 A2: Vergleichsbeispiel 1).

Die Methoden dieser Druckschriften sind jedoch in ihrer offengelegten Art und Weise, insbesondere wegen der Einzelstückbearbeitung und aufgrund der vergleichsweise hohen Temperaturen, äußerst aufwendig und kostenintensiv. Durch die Beschränkung der Dicke und der Fließspannung der verwendeten Bodenplatten, wie in der EP 2 214 202 A2 beschrieben, folgt weiterhin auch eine Limitierung der möglichen Anwendungsgebiete. Ursache für die Limitierung der Fließspannung sind dabei die unter thermischer Belastung im System entstehenden mechanischen Spannungen, welche durch die vorgeschlagenen geringen Fließspannungswerte auf ihr für das Keramik-Substrat verträgliche Werte reduziert werden.

Schließlich wird in der neueren Literatur das Sintern oder Diffusionsbonden zum stoffschlüssigen Verbinden von Keramik-Substraten mit Metallkörpern vorgeschlagen.

Die Niedertemperatur-Sintertechnologie, welche in den letzten Jahren insbesondere für den Die-Attach erfolgreich eingesetzt wird, ist jedoch für das Fügen der Keramik-Substrate an Metallkörper nur bedingt geeignet, da bei diesem Verfahren Drücke im Bereich von 2 MPa bis 20 MPa zum Herstellen der Sinterfügeverbindung angewendet werden müssen. Für eine typische Substratgröße von 30x40 mm² ist bei einem Fügedruck von 2 MPa (z. B. bei Nanosilbertechnologie) bereits eine Kraft von 2,4 kN aufzubringen.

Vielfach werden die Metallkörper, insbesondere die Bodenplatten, der Metall-Keramik-Module, insbesondere der leistungselektronischen Bauelemente, mit geeigneten Methoden, wie z. B. Schrauben oder Klemmen, an die zur Wärmeabführung notwendigen Kühlkörper befestigt. Da der Wärmetransfer zwischen Metallkörper und Kühleroberfläche, insbesondere zwischen Modul-Bodenplatte und Kühleroberfläche, durch die Oberflächenrauhigkeiten und/oder Oberflächenwelligkeiten nur in lokal begrenzten kleinen Bereichen erfolgen kann, werden bei der Montage Koppelmedien, sogenannte Thermal-Interface-Materialien (TIM), verwendet, welche die Unebenheiten in der Grenzfläche zwischen Metallkörper und Kühleroberfläche, insbesondere zwischen Modul-Bodenplatte und Kühleroberfläche, ausfüllen und so für einen besseren Wärmetransfer sorgen.
Allerdings erhöht das bei der Montage des Modulbodens an den Kühler erforderliche TIM den thermischen Widerstand des Gesamtsystems, da die derzeit verfügbaren TIM Materialien nur thermische Leitfähigkeiten zwischen 0,5 bis max. 10 K/W*m besitzen.
Eine weitere Möglichkeit zur besseren Kühlung von leistungselektronischen Baugruppen ist der direkte Kontakt des Kühlmediums mit der Keramik-Substratunterseite, wobei die Keramik-Substrate in einem geeigneten Formkörper fixiert werden und durch entsprechend ausgeführte Dichtungen das Eintreten von Kühlmedium in das Bauelement verhindert wird (z. B. Danfoss ShowerPower®). Allerdings ist das direkte Kühlen der Keramik-Substrate mit dem Kühlmedium im Modulaufbau (z. B. Danfoss ShowerPower®) durch den maximal möglichen Druck des Kühlmediums limitiert, da mit steigendem Druck die Gefahr des Eindringens von Kühlmedium in das Bauteil ebenfalls steigt. Des weiteren können die mit dem Kühlmedium in direktem Kontakt stehenden Substratunterseiten nur bedingt in ihrer Oberfläche vergrößert werden, so dass in diesem Falle kein optimierter Kontakt zwischen Keramik-Substrat und Kühlmedium besteht, was sich wiederum negativ auf den Wärmetransfer auswirkt.
Schließlich ist auch bekannt, dass durch den Einsatz von besser an den Wärmeausdehnungskoeffizienten der Keramik-Substrate angepassten Materialien, wie z. B. AlSiC, MoCu, WCu, CuMoCu oder Cu/Invar/Cu, qualitativ hochwertige Metall-Keramik-Module erhalten werden können. Allerdings erfordert dies ebenfalls eine der bekannten Fügetechnologien zum Verbinden von Keramik-Substrat und Boden, wie z. B. Löten oder Sintern mit den vorstehend beschriebenen Nachteilen, und ist darüber hinaus auf Grund der hohen Materialkosten für die Bodenplattenmaterialien nur für Module mit sehr hohen Anforderungen an die Zuverlässigkeit, wie z. B. Raumfahrt, umsetzbar.

Aus der EP 1 187 198 A2 ist eine Anordnung bekannt, die ein Metall-Keramik-Substrat und einen Metallkörper aufweist. Das Metall-Keramik-Substrat dient als Schaltungsträger (Substrat) für die Schaltkreise, während der Metallkörper zur Abfuhr von Wärme dient (Kühlkörper). Die Verbindung von Metall-Keramik-Substrat und Metallkörper erfolgt ohne Zwischenlage einer weiteren Schicht. Die Lehre liegt vielmehr darin, eine Aluminiumschmelze direkt auf die Oberfläche das Keramik-Substrats aufzubringen. Dadurch wird ein direkter Verbund zwischen beiden Materialien ohne Zwischenlage einer weiteren Schicht geschaffen.
Die EP 1 298 108 A2 beschreibt ein Metall-Keramik-Substrat, das an der Ober- und Unterseite mit einer Metallisierung versehen ist, die an Ober- und Unterseite der Keramik eine Schichtdicke von 0,25 bis 0,4 mm hat.

Die EP 0 726 239 A2 beschreibt eine Keramik-Struktur, die ein keramisches Substrat aus Aluminiumnitrid (AIN) mit einem gitterförmigen Heizelement aufweist. Das Keramiksubstrat weist Ausnehmungen auf, in denen die metallischen Endstücke von Elektroden befestigt sind. Die Endstücke der Elektroden werden mit dem Keramiksubstrat verlötet. Hierzu wird eine Al-Mg-Sandwichstruktur 18A verwendet, die auf den Boden der Ausnehmung aufgelegt wird. Die Al-Mg-Sandwichstruktur 18A umfasst ein inneres Einsatzstück 20A, das an beiden Seiten mit einer Al-Mg-Folie 19A, 19B versehen ist.
EP2006895 zeigt einen Modul mit einer keramischen Platte, die an beiden Seiten mittels einer Aluminiumlegierunglötverbindung mit Aluminiumlegierungsplatten verbunden ist. Die eine Al-Platte hat eine Dicke von 0,25 mm, die andere Al-Platte von 0,1-0,5 mm. Ein Metallkühlkörper wird mittels einer Aluminiumlegierunglötverbindung mit einer Liquidustemperatur > 600°C bei 300-500°C mit einer der Al-Platte verbunden. US6033787 zeigt auch einen Modul mit einer keramischen Platte, die an beiden Seiten mittels einer Aluminiumlegierunglötverbindung mit Aluminiumlegierungsplatten verbunden ist. Ein Metallkühlkörper wird bei 570-610°C mit der einer der Al-Platten verbunden. Die Al-Platten und haben eine Dicke von 0,4 mm, der Metallkörper von 2 mm.

EP1450401 zeigt einen Modul mit einer keramischen Platte, die an beiden Seiten mittels einer Aluminiumlötverbindung mit Aluminiumplatten verbunden ist. Ein Metallkühlkörper wird mittels einer Aluminiumlötverbindung bei 600°C mit einer der Platten verbunden. Eine Platte hat eine Dicke von 0,4 mm, die andere Platte von 0,4-1,2 mm. Der Metallkörper hat einer Dicke von 4 mm.

JP2007281498 zeigt einen Schaltungsträger, wobei der Metallkühlkörper eine Dicke < 1 mm hat.

In Anbetracht dieses Standes der Technik war es eine Aufgabe der vorliegenden Erfindung, bessere Möglichkeiten zum Fügen von Metall-Keramik-Substraten an Metallkörper aufzuzeigen. Gesucht wurden vor allem bessere Möglichkeiten zur Anbindung von Metallkörpern an Keramik-Substrate mit mindestens einseitiger Metallisierung, insbesondere zur festeren und beständigeren Anbindung von Metall-Kühlkörpern an Keramik-Substrate mit mindestens einseitiger Metallisierung, damit die Fügestelle möglichst auch einer thermischen Wechselbelastung sehr gut standhält. Die Bildung von Rissen und Delaminationen an der Fügestelle bei solchen thermischen Wechselbelastungen sollte bestmöglich vermieden werden, um bessere Langzeit-Eigenschaften, insbesondere einen besseren Langzeit-Wärmetransfer, des Metall-Keramik-Moduls zu gewährleisten und um das Risiko eines Ausfalls des Metall-Keramik-Moduls in der Anwendung zu minimieren. Der Einsatz von weiteren Verbindungsmitteln, insbesondere von Schrauben, Klemmen oder anderen Koppelmedien, wie z. B. Thermal-Interface-Materialien (TIM), sollte nach Möglichkeit vermieden werden. Gleichzeitig sollte die erfindungsgemäße Lösung auf möglichst einfache Art und Weise, möglichst kostengünstig und effizient realisiert werden können.

Gelöst werden diese sowie weitere Aufgaben, die sich aus den hier diskutierten Zusammenhängen in unmittelbarer Weise ergeben, durch ein Verfahren zur Herstellung eines Metall-Keramik-Moduls mit allen Merkmalen des Patentanspruchs 1. Die auf Anspruch 1 rückbezogenen Unteransprüche beschreiben bevorzugte Varianten des erfindungsgemäßen Verfahrens. Weiterhin werden das erfindungsgemäße Metall-Keramik-Modul sowie besonders zweckmäßige Anwendungsgebiete des erfindungsgemäßen Metall-Keramik-Moduls unter Schutz gestellt. Das erfindungsgemäße Verfahren erlaubt eine Anbindung von Metallkörpern an Keramik-Substrate und ermöglicht insbesondere eine festere und beständigere Anbindung von Metallkörpern an Keramik-Substrate, wobei die Fügestelle auch einer thermischen Wechselbelastung sehr gut standhält. Die Bildung von Rissen und Delaminationen an der Fügestelle bei solchen thermischen Wechselbelastungen wird bestmöglich vermieden und gewährleistet so bessere Langzeit-Eigenschaften, insbesondere einen besseren Langzeit-Wärmetransfer, der Metall-Keramik-Module und das Risiko eines Ausfalls des Metall-Keramik-Moduls in der Anwendung ist vergleichsweise gering. Durch die erfindungsgemäße Beschränkung der Dicke der Metallkörper auf kleiner 1 mm werden bei thermischer Belastung des Verbundes aus Metall-Keramik-Substrat und Metallkörper nur geringe, für das Metall-Keramik-Substrat unkritische, mechanische Spannungen erzeugt, so dass eine Limitierung der Fließspannung der einzusetzenden Metallkörper nicht erforderlich ist. Der Einsatz von weiteren Verbindungsmitteln, insbesondere von Schrauben, Klemmen oder anderen Koppelmedien, wie z. B. Thermal-Interface-Materialien (TIM), ist im Rahmen der vorliegenden Erfindung nicht zwingend erforderlich. Weiterhin lässt sich die erfindungsgemäße Lösung auf vergleichbar einfache Art und Weise, äußerst kostengünstig und effizient realisieren.

Gegenstand der vorliegenden Erfindung ist dementsprechend ein Verfahren zum Verbinden eines Metall-Keramik-Substrats mit einem Metallkörper mittels einer Metalllegierung, bei welchem zunächst man eine Metalllegierung zwischen dem Metall-Keramik-Substrat und dem Metallkörper anordnet.

Das erfindungsgemäß einzusetzende Metall-Keramik-Substrat umfasst ein Keramik-Substrat sowie mindestens einseitig eine Metallisierung.

Bei dem Keramik-Substrat handelt es sich vorzugsweise um ein anorganisches, nichtmetallischen Substrat, insbesondere ein Tonmineral. Bevorzugte Keramik-Substrate umfassen Oxide und Nitride, vor allem Aluminiumoxid, Aluminiumnitrid und Siliziumnitrid, insbesondere Aluminiumoxid.

Im Rahmen der vorliegenden Erfindung umfasst das Keramik-Substrat auf mindestens einer Oberfläche eine Metallisierung, bevorzugt aus Aluminium oder Kupfer, insbesondere aus Aluminium.

Die elektrische Leitfähigkeit der Metallisierung ist zweckmäßigerweise größer 10² (Ω·cm)⁻¹, bevorzugt größer 10³ (Ω·cm)⁻¹, besonders bevorzugt größer 10⁴ (Ω·cm)⁻¹, insbesondere größer 10⁵ (Ω·cm)⁻¹.

Im Rahmen der vorliegenden Anmeldung beziehen sich alle Angaben auf eine Temperatur von 25°C, sofern nicht anderes angegeben wird.

Die Dicke der Metallisierung ist vorzugsweise größer 50,0 µm, bevorzugt größer 75,0 µm, besonders bevorzugt größer 100,0 µm, ganz besonders bevorzugt größer 150,0 µm, insbesondere größer 200,0 µm. Weiterhin ist die Dicke der Metallisierung kleiner 1.000,0 µm, bevorzugt kleiner 750,0 µm, besonders bevorzugt kleiner 500,0 µm, insbesondere kleiner 400,0 µm.

Die Metallisierung wird vorzugsweise durch ein Direct-Bonding-Verfahren auf die Oberfläche des Keramik-Substrats aufgebracht. Hierzu gehören insbesondere solche Verfahren, wie das Direct Copper Bonding (DCB), das Direct Aluminium Bonding (DAB) und das Active Metal Brazing (AMB), bei welchen man das Metall bei hohen Temperaturen aufschmilzt, die resultierende Schmelze auf das Keramik-Substrat aufbringt und anschließend verfestigt. Solche Verfahren werden beispielsweise in den Anmeldungen EP 0 676 800 A2 und EP 1 187 198 A2 beschrieben.

Gemäß einer ersten besonders bevorzugten Ausführungsform der vorliegenden Erfindung weist das Keramik-Substrat auf seiner Oberseite und seiner Unterseite jeweils eine Metallisierung auf und der Metallkörper wird über eine dieser Seiten, bevorzugt die Unterseite, mit dem Keramik-Substrat verbunden.

Gemäß einer zweiten besonders bevorzugten Ausführungsform der vorliegenden Erfindung weist das Keramik-Substrat nur auf seiner Oberseite eine Metallisierung auf und der Metallkörper wird über die Unterseite des Keramik-Substrats mit diesem verbunden.

Zweckmäßigerweise weist mindestens eine metallisierte Seite eine schaltungstechnische Struktur auf.

Bei dem erfindungsgemäß einzusetzenden Metallkörper handelt es sich vorzugsweise um ein Blech.

Die Dicke des Metallkörpers ist erfindungsgemäß kleiner 1,0 mm, bevorzugt kleiner 0,9 mm, besonders bevorzugt kleiner 0,8 mm, ganz besonders bevorzugt kleiner 0,7 mm, insbesondere kleiner 0,6 mm. Weiterhin ist die Dicke des Metallkörpers vorzugsweise größer 0,05 mm, bevorzugt größer 0,075 mm, besonders bevorzugt größer 0,1 mm, ganz besonders bevorzugt größer 0,2 mm, insbesondere größer 0,3 mm. Die Dicke des Metallkörpers wird vorzugsweise senkrecht zur Fügeverbindung ermittelt.

Im Übrigen unterliegt der mit dem Metall-Keramik-Substrat zu fügenden Metallkörper grundsätzlich keinen besonderen Beschränkungen. Er dient jedoch vorzugsweise dazu, die im leistungselektronischen Bauteil während des Betriebes entstehende Wärme weiter- oder abzuleiten. Aus diesem Grund ist die dem Metallkörper zugewandte Seite des Metall-Keramik-Substrats vorzugsweise kleiner als die dem Metall-Keramik-Substrat zugewandte Seite des Metallkörpers, um eine besonders effiziente Kühlwirkung sicherzustellen.

Im Rahmen der vorliegenden Erfindung weist der Metallkörper vorzugsweise die folgenden Stoffeigenschaften auf:
1. hohe elektrische Leitfähigkeit,
2. hohe Wärmeleitfähigkeit,
3. Duktilität (Verformbarkeit) und
4. metallischer Glanz (Spiegelglanz).

Bevorzugte Metallkörper sind aus chemischen Elementen gebildet, die sich im Periodensystem der Elemente links und unterhalb einer Trennungslinie von Bor bis Astat befinden. Für die Zwecke der vorliegenden Erfindung ganz besonders günstige Metallkörper sind Aluminium und Kupfer, insbesondere Aluminium. Für Hochleistungsanwendungen haben sich weiterhin Metallkörper als vorteilhaft erwiesen, die AlSiC, MoCu, WCu, CuMoCu und/oder Cu/Invar/Cu umfassen.

Bei der Metalllegierung handelt es sich um einen Werkstoff aus zwei oder mehreren Legierungselementen, die metallurgisch miteinander in Wechselwirkung treten. Dementsprechend umfasst die Legierung Aluminium sowie ein weiteres Legierungselement, bevorzugt ein Element der II. oder der IV. Hauptgruppe des Periodensystems der Elemente, zweckmäßigerweise Magnesium (Mg) oder Silizium (Si), insbesondere Silizium.

Der Aluminiumgehalt der Legierung ist erfindungsgemäß größer 0,0 Gew.-% und kleiner 100,0 Gew.-%, vorzugsweise größer 50,0 Gew.-%, besonders bevorzugt größer 70,0 Gew.-%, zweckmäßigerweise größer 75,0 Gew.-%, günstigerweise größer 80,0 Gew.-%, insbesondere größer 85,0 Gew.-%, jeweils bezogen auf das Gesamtgewicht der Legierung.

Im Rahmen einer besonders bevorzugten Variante der vorliegenden Erfindung enthält die Legierung Silizium als weiteres Legierungselement. Der Siliziumgehalt der Legierung ist dabei vorzugsweise größer 0,1 Gew.-%, bevorzugt größer 4,0 Gew.-%, besonders bevorzugt größer 5,0 Gew.-%, zweckmäßigerweise größer 7,5 Gew.-%, günstigerweise größer 10,0 Gew.-%, insbesondere größer 11,5 Gew.-%, jeweils bezogen auf das Gesamtgewicht der Legierung.

Weiterhin ist der Siliziumgehalt der Legierung vorzugsweise kleiner 30,0 Gew.-%, bevorzugt kleiner 25,0 Gew.-%, besonders bevorzugt kleiner 20,0 Gew.-%, zweckmäßigerweise kleiner 15,0 Gew.-%, günstigerweise kleiner 13,5 Gew.-%, insbesondere kleiner 12,5 Gew.-%, jeweils bezogen auf das Gesamtgewicht der Legierung.

Ganz besonders günstige Ergebnisse werden unter Verwendung einer Legierung, bestehend aus 88,0 Gew.-% Aluminium und 12,0 Gew.-% Silizium, jeweils bezogen auf das Gesamtgewicht der Legierung, erzielt.

Darüber hinaus ist auch der Einsatz von Legierungen vorteilhaft, die aus Aluminium, 4,0 Gew.-% bis 12,0 Gew.-% Silizium und neben herstellungsbedingten Verunreinigungen von maximal 0,1 Gew.-% noch aus wenigstens zwei zusätzlichen Legierungskomponenten bestehen, die ausgewählt sind aus
a) 0,5 Gew.-% bis 32,0 Gew.-% Kupfer,
b) 0,5 Gew.-% bis 8,0 Gew.-% Zinn,
c) 0,2 Gew.-% bis 2,0 Gew.-% Magnesium,
d) 0,2 Gew.-% bis 8,0 Gew.-% Silber, jeweils bezogen auf das Gesamtgewicht der Legierung,
wobei sich alle Legierungskomponenten zu 100,0 Gew.-% addieren. Die in der Legierung enthaltenen Verunreinigungselemente, zum Beispiel Eisen und Mangan, sollten zweckmäßigerweise jeweils 0,05 Gew.-%, bezogen auf das Gesamtgewicht der Legierung, nicht übersteigen.

In einer besonders bevorzugten Ausführungsform der Erfindung sind die zusätzlichen Legierungskomponenten ausgewählt aus
a-1) 23,0 Gew.-% bis 32,0 Gew.-% Kupfer und
d-1) 0,1 Gew.-% bis 8,0 Gew.-% Silber, jeweils bezogen auf das Gesamtgewicht der Legierung.

In einer anderen bevorzugten 4-Stofflegierung sind die weiteren Legierungskomponenten ausgewählt aus
a-2) 0,5 Gew.-% bis 8,0 Gew.-% Kupfer und
d-2) 0,1 Gew.-% bis 8,0 Gew.-% Silber, jeweils bezogen auf das Gesamtgewicht der Legierung.

In einer weiteren bevorzugten Legierung sind die weiteren Legierungskomponenten ausgewählt aus
a-3) 0,5 Gew.-% bis 8,0 Gew.-% Kupfer und
b-3) 0,2 Gew.-% bis 8,0 Gew.-% Zinn und c-3) 0,2 Gew.-% bis 2,0 Gew.-% Magnesium, jeweils bezogen auf das Gesamtgewicht der Legierung.

Besonders geeignet sind auch Legierungen, bei denen die weiteren Legierungskomponenten Zinn und Magnesium mit den folgenden Konzentrationen sind
b-4) 0,5 Gew.-% bis 8,0 Gew.-% Zinn und
c-4) 0,1 Gew.-% bis 2,0 Gew.-% Magnesium, jeweils bezogen auf das Gesamtgewicht der Legierung.

Als besonders geeignet, insbesondere für die Verwendung zum Hartlöten von Aluminium-Fügungen, haben sich Al-Si-Legierungen erwiesen, die aus Aluminium, 4,0 Gew.-% bis 12,0 Gew.-% Silizium und neben herstellungsbedingten Verunreinigungen von maximal 0,1 Gew.-% noch aus folgenden Legierungs-Komponenten bestehen
a-5) 0,5 Gew.-% bis 8,0 Gew.-% Kupfer und
d-5) 1,0 Gew.-% bis 8,0 Gew.-% Silber, wobei sich die Angaben jeweils auf das Gesamtgewicht der Legierung beziehen.

Es hat sich gezeigt, dass der erhöhte Silbergehalt dieser Legierungen die Schmelztemperatur weiter vermindert und die Benetzung der Fügepartner verbessert.

Als eine weitere Gruppe von Al-Si-Legierungen, die sehr gut für die Verwendung zum Hartlöten von Aluminium-Fügungen geeignet sind, haben sich Al-Si-Legierungen erwiesen, die aus Aluminium, 4,0 Gew.-% bis 12 Gew.-% Silizium und neben herstellungsbedingten Verunreinigungen von maximal 0,1 Gew.-% noch aus folgenden Legierungs-Komponenten bestehen
2,0 Gew.-% bis 8,0 Gew.-% Kupfer,
0,2 Gew.-% bis 3,0 Gew.-% Zinn,
0,2 Gew.-% bis 2,0 Gew.-% Magnesium, wobei sich die Angaben jeweils auf das Gesamtgewicht der Legierung beziehen.

Im Rahmen einer weiteren besonders bevorzugten Variante der vorliegenden Erfindung enthält die Legierung Magnesium als weiteres Legierungselement. Der Magnesiumgehalt der Legierung ist dabei vorzugsweise größer 0,1 Gew.-%, bevorzugt größer 0,5 Gew.-%, besonders bevorzugt größer 1,0 Gew.-%, zweckmäßigerweise größer 1,5 Gew.-%, günstigerweise größer 2,0 Gew.-%, insbesondere größer 2,5 Gew.-%, jeweils bezogen auf das Gesamtgewicht der Legierung. Weiterhin ist der Magnesiumgehalt der Legierung vorzugsweise kleiner 10,0 Gew.-%, bevorzugt kleiner 9,0 Gew.-%, besonders bevorzugt kleiner 8,0 Gew.-%, zweckmäßigerweise kleiner 7,0 Gew.-%, günstigerweise kleiner 6,0 Gew.-%, insbesondere kleiner 5,5 Gew.-%, jeweils bezogen auf das Gesamtgewicht der Legierung.

Die in der Legierung enthaltenen Verunreinigungselemente, zum Beispiel Eisen und Mangan, sollten zweckmäßigerweise jeweils 0,05 Gew.-%, bezogen auf das Gesamtgewicht der Legierung, nicht übersteigen.

Im Rahmen der vorliegenden Erfindung ist es besonders vorteilhaft, wenn das Keramik-Substrat, die Metalllegierung und vorzugsweise auch der Metallkörper eine große chemische Ähnlichkeit aufweisen. Daher umfassen das Keramik-Substrat, die Metalllegierung und vorzugsweise auch der Metallkörper zweckmäßigerweise mindestens ein gemeinsames Element, dessen Gewichtsanteil in jeder Komponente günstigerweise größer 25,0 Gew.-%, bevorzugt größer 50,0 Gew.-%, jeweils bezogen auf das Gesamtgewicht der Komponente, ist. Bevorzugt handelt es sich bei dem gemeinsamen Element um Aluminium.

Die Liquidustempertur der Metalllegierung ist erfindungsgemäß größer 450°C, bevorzugt größer 500°C, besonders bevorzugt größer 550°C, insbesondere größer 575°C. Weiterhin ist die Liquidustempertur der Metalllegierung zweckmäßigerweise kleiner 650°C, bevorzugt kleiner 625°C, besonders bevorzugt kleiner 600°C, ganz besonders bevorzugt kleiner 590°C, insbesondere kleiner 580°C.

Die Liquidustempertur bezeichnet im Rahmen der vorliegenden Erfindung die Temperatur, oberhalb welcher die Legierung vollständig flüssig ist.

Die Solidustemperatur der Metalllegierung ist vorzugsweise größer 450°C, bevorzugt größer 500°C, besonders bevorzugt größer 550°C, insbesondere größer 575°C. Weiterhin ist die Solidustemperatur zweckmäßigerweise kleiner 650°C, bevorzugt kleiner 625°C, besonders bevorzugt kleiner 600°C, ganz besonders bevorzugt kleiner 590°C, insbesondere kleiner 580°C.

Die Solidustemperatur bezeichnet im Rahmen der vorliegenden Erfindung die Temperatur, unterhalb welcher die Legierung vollständig fest ist.

Die Dicke der Metalllegierung ist im Rahmen einer besonders bevorzugten Ausführungsform der vorliegenden Erfindung größer 50,0 µm, bevorzugt größer 75,0 µm, besonders bevorzugt größer 100,0 µm, ganz besonders bevorzugt größer 150,0 µm, insbesondere größer 200,0 µm. Weiterhin ist die Dicke der Metalllegierung zweckmäßigerweise kleiner 1.000,0 µm, bevorzugt kleiner 750,0 µm, besonders bevorzugt kleiner 500,0 µm, insbesondere kleiner 250,0 µm.

Die Dicke des Keramik-Substrats unterliegt keinen besonderen Beschränkungen. Jedoch hat sich die erfindungsgemäße Vorgehensweise vor allem für Keramik-Substrate mit einer Dicke kleiner 2.000,0 µm, bevorzugt kleiner 1.500,0 µm, besonders bevorzugt kleiner 750,0 µm, ganz besonders bevorzugt kleiner 500,0 µm, insbesondere kleiner 400,0 µm, besonders bewährt. Weiterhin ist die Dicke des Keramik-Substrats vorzugsweise größer 50,0 µm, bevorzugt größer 75,0 µm, besonders bevorzugt größer 100,0 µm, ganz besonders bevorzugt größer 200,0 µm, insbesondere größer 300,0 µm.

Die vorstehenden Werte für die Dicken der Metalllegierung, des Keramik-Substrats, der Metallisierung und des Metallkörpers werden zweckmäßigerweise senkrecht zu den Kontaktflächen Keramik-Substrat/Metalllegierung/Metallkörper ermittelt.

Bei einer ungleichmäßigen Dicke der Metalllegierung bezieht sich die Angabe auf den kleinsten Wert (Mindestdicke).

Bei gekrümmten Oberflächen wird die Dicke jeweils in Normalenrichtung zu den Kontaktflächen Keramik-Substrat/Metalllegierung/Metallkörper ermittelt und die Angabe bezieht sich wiederum auf den kleinsten Wert (Mindestdicke).

Die elektrische Leitfähigkeit des Keramik-Substrats, des Metallkörpers und der Metalllegierung kann prinzipiell frei gewählt werden. Zweckmäßigerweise ist die elektrische Leitfähigkeit des Metallkörpers jedoch größer 10² (Ω·cm)⁻¹, bevorzugt größer 10³ (Ω·cm)⁻¹, besonders bevorzugt größer 10⁴ (Ω·cm)⁻¹, insbesondere größer 10⁵ (Ω·cm)⁻¹

Die elektrische Leitfähigkeit der Metalllegierung ist zweckmäßigerweise kleiner als die elektrische Leitfähigkeit des Metallkörpers. Sie ist vorzugsweise kleiner 10² (Ω·cm)⁻¹, bevorzugt kleiner 10¹ (Ω·cm)⁻¹, besonders bevorzugt kleiner 10⁰ (Ω·cm)⁻¹, zweckmäßigerweise kleiner 10⁻¹ (Ω·cm)⁻¹, ganz besonders bevorzugt kleiner 10⁻² (Ω·cm)⁻¹, insbesondere kleiner 10⁻³ (Ω·cm)⁻¹. Weiterhin ist die elektrische Leitfähigkeit der Metalllegierung vorzugsweise größer 10⁻⁸ (Ω·cm)^{- 1}, bevorzugt größer 10⁻⁷ (Ω·cm)⁻¹, besonders bevorzugt größer 10⁻⁶ (Ω·cm)⁻¹, insbesondere größer 10⁻⁵ (Ω·cm)⁻¹.

Die elektrische Leitfähigkeit des Keramik-Substrats ist zweckmäßigerweise kleiner als die elektrische Leitfähigkeit der Metalllegierung. Sie ist vorzugsweise kleiner 10⁻⁶ (Ω·cm)⁻¹, bevorzugt kleiner 10⁻⁸ (Ω·cm)⁻¹, besonders bevorzugt kleiner 10⁻¹⁰ (Ω·cm)⁻¹, zweckmäßigerweise kleiner 10⁻¹² (Ω·cm)⁻¹, insbesondere kleiner 10⁻¹⁴ (Ω·cm)⁻¹.

Das erfindungsgemäße Verfahren ermöglicht es, strukturierte oder unstrukturierte Metall-Keramik-Substrate, wie z. B. DAB-Substrate oder DCB-Substrate, an Metallkörper zu fügen. Vorzugsweise sind diese Metallkörper aus Aluminium und können die Form von Kühlkörpern besitzen, wie diese typischer Weise zur Wärmeableitung in elektronischen Bauteilen verwendet werden.

Zum Verbinden des Metall-Keramik-Substrats und des Metallkörpers wird die Anordnung, umfassend das Metall-Keramik-Substrat, die Metalllegierung und den Metallkörper, auf eine Temperatur größer 450°C, bevorzugt größer 500°C, besonders bevorzugt größer 550°C, insbesondere größer 575°C, erwärmt. Dabei wird die Anordnung vorzugsweise auf eine Temperatur kleiner 900°C, bevorzugt kleiner 800°C, besonders bevorzugt kleiner 700°C, insbesondere kleiner 650°C, erwärmt. Nach dem Verflüssigen der Legierung wird diese vorzugsweise wieder verfestigt, günstigerweise indem man die Anordnung, umfassend das Metall-Keramik-Substrat, die Metalllegierung und den Metallkörper, auf eine Temperatur kleiner 450°C, bevorzugt kleiner 300°C, besonders bevorzugt kleiner 200°C, noch mehr bevorzugt kleiner 100°C, insbesondere kleiner 50°C, abkühlt.

Zum Fügen von Metall-Keramik-Substrat und Metallkörper wird die Anordnung, umfassend das Metall-Keramik-Substrat, die Metalllegierung und den Metallkörper, zweckmäßigerweise in einen Ofen, wie z. B. einen Durchlaufofen, eingebracht und vorzugsweise auf eine Temperatur oberhalb der Schmelztemperatur der Fügeschicht, zweckmäßigerweise aber unterhalb der Schmelzpunkte von der ggf. vorhandenen Keramik-Substratmetallisierung und von dem Metallkörper erhitzt. Dabei erfolgt das Verbinden von Keramik-Substrat und Metallkörper zweckmäßigerweise unter Inertgasatmosphäre. Durch das Aufschmelzen der Fügeschicht werden die ggf. vorhandene Keramik-Substratmetallisierung und der Metallkörper vorzugsweise mit der Legierung benetzt und sind durch die ablaufenden Diffusionsprozesse nach dem Abkühlen stoffschlüssig verbunden. Ganz besonders bewährt hat sich eine Vorgehensweise, bei welcher man die Anordnung, umfassend das Metall-Keramik-Substrat, die Metalllegierung und den Metallkörper, ausgehend von einer Temperatur kleiner 450°C, bevorzugt kleiner 300°C, besonders bevorzugt kleiner 200°C, noch mehr bevorzugt kleiner 100°C, insbesondere kleiner 50°C, kontinuierlich auf eine Temperatur größer 450°C, bevorzugt größer 500°C, besonders bevorzugt größer 550°C, insbesondere größer 575°C, erwärmt und dann wieder kontinuierlich auf eine Temperatur kleiner 450°C, bevorzugt kleiner 300°C, besonders bevorzugt kleiner 200°C, noch mehr bevorzugt kleiner 100°C, insbesondere kleiner 50°C, abkühlt.

Alternative Methoden zum Verbinden des Keramik-Substrats und des Metallkörpers schließen Plasmalöten, Laserlöten, Flammlöten und Induktionslöten ein. Allerdings hat sich das Ofenlöten für die Zwecke der vorliegenden Erfindung ganz besonders bewährt.

Die Verbindungsbildung zwischen Metall-Keramik-Substrat und Metallkörper wird durch die in diese Grenzfläche eingebrachte Schicht aus der Metalllegierung realisiert, welche vorzugsweise einen geringeren Schmelzpunkt als die ggf. vorhandene Substratmetallisierung und der Metallkörper besitzt sowie deren Oberflächen während des Fügevorgangs möglichst gut benetzt. Diese Schicht kann entweder fest mit mindestens einem Fügepartner (Metall-Keramik-Substrat und/oder Metallkörper) verbunden sein oder als loses Plättchen zwischen der zu verbindenden Metall-Keramik-Substratseite und dem Metallkörper eingelegt werden.

Durch das Aufbringen einer Vielzahl, in ihrer lateralen Ausdehnung auf ein Optimum beschränkten, strukturierten Metall-Keramik-Substraten auf einen gemeinsamen Metallformkörper und nach Herstellung geeigneter elektrischer Verbindungen zwischen diesen Metall-Keramik-Substraten, sind zuverlässige Gesamtschaltungen auch für höhere Leistungen möglich.

Das Bestücken der Metall-Keramik-Substrate mit den elektrischen Komponenten, wie z. B. Halbleiterchips, Thermistoren usw., und die Herstellung der elektrischen Verschaltung erfolgt vorzugsweise mit geeigneten, dem Fachmann bekannten, Methoden nach der Verbindungsherstellung zwischen Metall-Keramik-Substrat und Metallkörper.

Im Rahmen der vorliegenden Erfindung wird die Oberfläche des resultierenden Metall-Keramik-Moduls vorzugsweise zumindest teilweise mit Nickel, Gold, Silber und/oder einem Schichtsystem dieser Materialien beschichtet.

Das erfindungsgemäß erhältliche Metall-Keramik-Modul ist insbesondere durch eine sehr feste Anbindung des Metallkörpers an das Keramik-Substrat gekennzeichnet. Die benötigte Abschälkraft zum Trennen von Keramik-Substrat und Metallkörper ist vorzugsweise größer 3 N/mm.

Bevorzugte Anwendungsgebiete des erfindungsgemäß erhältlichen Metall-Keramik-Moduls schließen seine Verwendung als Schaltungsträger in elektronischen Geräten ein, wobei der Metallkörper des Metall-Keramik-Moduls vorzugsweise als Kühlkörper fungiert.

Nachfolgend wird die Erfindung durch mehrere Beispiele weiter erläutert, ohne dass hierdurch eine Beschränkung des Erfindungsgedankens erfolgen soll.

### Beispiel 1 - Fügen beidseitig metallisierter und einseitig strukturierter DAB-Substrate an ein mit Al-Si-beschichtetes Aluminiumblech

Bei diesem Ausführungsbeispiel werden DAB-Keramik-Substrate mit einer lateralen Größe von 36 mm x 20 mm (Al₂O₃-Keramik (Dicke 0,38 mm) mit beidseitiger Al-Metallisierung (Dicke 0,3 mm), wobei die Oberseite des DAB-Substrats schaltungstechnisch strukturiert ist) an ein 0,2 mm dickes, einseitig mit Al-Si beschichtetes Aluminiumblech gefügt.

Für den Fügevorgang werden die zu fügenden Substrate mit der unstrukturierten Seite auf die mit Al-Si beschichtete Seite des Aluminiumblechs an definierten Positionen aufgelegt.

Eine Prinzipskizze durch den Querschnitt des Aufbaus wird in Figur A gezeigt, wobei das metallisierte Keramik-Substrat eine Keramik (2) und beidseitig eine Metallisierung (1, 3) umfasst und die Fügeschicht (4) fest mit dem Aluminiumblech (5) verbunden ist.

Dieser Stack wird auf das Transportband eines Durchlaufofens mit einer Mehrzahl von Heizzonen aufgelegt und mit konstanter Transportgeschwindigkeit durch den Ofen bewegt und dabei bis zu einer Temperatur zwischen 580°C und 650°C aufgeheizt. Nach dem Durchlaufen der Heizzonen erfolgt das Abkühlen auf Raumtemperatur (25°C). Der Ofenprozess erfolgt hierbei unter N₂-Atmosphäre.

Nach dem Fügevorgang sind das Keramik-Substrat und das Aluminiumblech stoffschlüssig miteinander verbunden, wobei die Abschälkraft zum Trennen von Keramik-Substrat und Aluminiumblech größer 3 N/mm ist.

### Beispiel 2 - Fügen eines strukturierten DAB-Substrats an ein Aluminiumblech mittels lose aufgelegtem Al-Si-Plättchen

In diesem Ausführungsbeispiel wird ein DAB-Keramik-Substrat mit einer lateralen Größe von 36 mm x 20 mm (Al₂O₃-Keramik (Dicke 0,38 mm) mit beidseitiger AI-Metallisierung (Dicke 0,3 mm)) an ein 0,8 mm dickes Al-Blech gefügt, wobei die obere Metallisierung des DAB-Substrats schaltungstechnisch strukturiert ist. Vor dem Fügevorgang wird auf die Oberseite des Aluminiumblechs pro zu fügendes Substrat ein Al-Si-Plättchen der Größe 36 mm x 20 mm und der Dicke 0,075 mm an die definierten Positionen aufgebracht und darauf die unstrukturierte Unterseite des Keramik-Substrats positioniert.

Eine Prinzipskizze durch den Querschnitt des Aufbaus wird in Figur B gezeigt, wobei das metallisierte Keramik-Substrat eine Keramik (20) und beidseitig eine Metallisierung (10, 30) umfasst, die Fügeschicht (40) als Plättchen ausgeführt ist und das Aluminiumblech mit dem Bezugszeichen (50) gekennzeichnet ist.

Dieser Stack wird auf das Transportband eines Durchlaufofens mit einer Mehrzahl von Heizzonen aufgelegt und mit konstanter Transportgeschwindigkeit bis zu einer Temperatur zwischen 580°C und 650°C aufgeheizt und nach dem Durchlaufen der Heizzonen wieder auf Raumtemperatur abgekühlt. Der Ofenprozess erfolgt hierbei unter N₂-Atmosphäre.

Nach dem Fügevorgang sind das Keramik-Substrat und das Aluminiumblech stoffschlüssig miteinander verbunden.

### Beispiel 3 - Fügen einseitig metallisierter und strukturierter DCB-Substrate an ein mit Al-Si-beschichtetes Aluminiumblech

Bei diesem Ausführungsbeispiel werden DCB-Keramik-Substrate mit einer lateralen Größe von 36 mm x 20 mm (Al₂O₃-Keramik (Dicke 0,63 mm) und einer nur auf ihrer Oberseite angebrachten Cu-Metallisierung (Dicke 0,3 mm)) mit ihrer nicht beschichteten Unterseite an ein 0,5 mm dickes, einseitig mit Al-Si beschichtetes Aluminiumblech gefügt. Die Kupfermetallisierung der DCB-Substrate ist schaltungstechnisch strukturiert.

Für den Fügevorgang werden die zu fügenden Keramik-Substrate mit der Metallisierung nach oben auf die mit Al-Si beschichtete Seite des AI-Blechs aufgelegt. Eine Prinzipskizze durch den Querschnitt des Aufbaus wird in Figur C gezeigt, wobei das metallisierte Keramik-Substrat eine Metallisierung (100) und eine Keramik (200) umfasst und die Fügeschicht (300) fest mit dem Aluminiumblech (400) verbunden ist.

Die Fügeverbindung wird zwischen der Keramik des Substrates und dem Aluminiumblech (inkl. Zwischenschicht) hergestellt. Dieser Stack wird auf das Transportband eines Durchlaufofens mit einer Mehrzahl von Heizzonen aufgelegt und mit konstanter Transportgeschwindigkeit im Ofen bewegt und dabei bis zu einer Temperatur zwischen 580°C und 650°C aufgeheizt und nach dem Durchlaufen der Heizzonen wieder auf Raumtemperatur abgekühlt. Der Ofenprozess erfolgt dabei unter N₂-Atmosphäre.

Nach dem Fügevorgang sind das Substrat und das Aluminiumblech stoffschlüssig miteinander verbunden, wobei die Abschälkraft zum Trennen von Substrat und Aluminiumblech größer 3 N/mm ist.

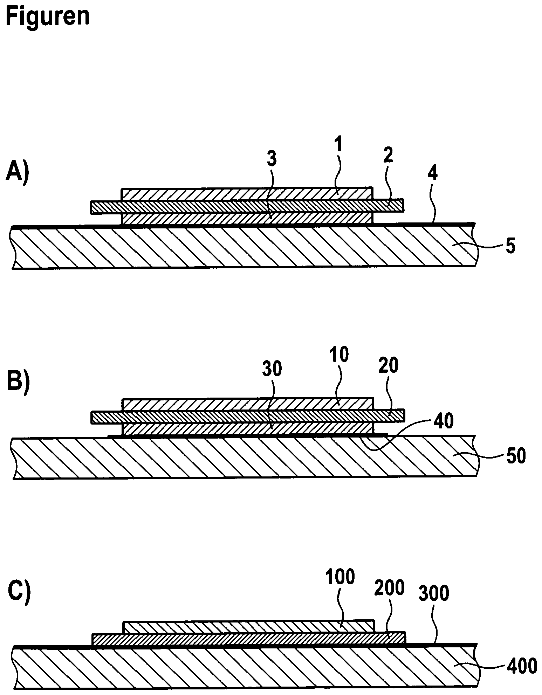

## Patentansprüche

1. Verfahren zur Herstellung eines Moduls als Schaltungsträger für eine schaltungstechnische Struktur mit folgenden Verfahrensschritten:
Verbinden eines Metall-Keramik-Substrates mit einem Metallkörper mittels einer Metalllegierung, wobei das Metall-Keramik-Substrat mindestens einseitig eine Metallisierung mit einer Dicke kleiner als 1.000,0 µm zum Aufbringen der schaltungstechnischen Struktur aufweist, und die dem Metallkörper zugewandte Seite des Metall-Keramik-Substrats kleiner als die dem Metall-Keramik-Substrat zugewandte Seite des Metallkörpers ist und man das Metall-Keramik-Substrat mit dem Metallkörper derart verbindet, dass das Metall-Keramik-Substrat auf der dem Metallkörper abgewandten Seite eine Metallisierung umfasst,
**dadurch gekennzeichnet, dass** man
a) einen Metallkörper mit einer Dicke kleiner 1 mm einsetzt,
b) eine Metalllegierung zwischen dem Metall-Keramik-Substrat und dem Metallkörper anordnet, die
b-1) Aluminium enthält und
b-2) eine Liquidustempertur größer 450°C aufweist,
c) die Anordnung aus Schritt b) auf eine Temperatur größer 450°C erwärmt.

2. Verfahren nach Anspruch 1, **dadurch gekennzeichnet, dass** man eine Legierung verwendet, die weiterhin Silizium enthält.

3. Verfahren nach Anspruch 1, **dadurch gekennzeichnet, dass** man eine Legierung verwendet, die weiterhin Magnesium enthält.

4. Verfahren nach mindestens einem der vorangehenden Ansprüche, **dadurch gekennzeichnet, dass** man eine Legierung verwendet, die mehr als 50,0 Gew.-% Aluminium, bezogen auf das Gesamtgewicht der Legierung, enthält.

5. Verfahren nach mindestens einem der vorangehenden Ansprüche, **dadurch gekennzeichnet, dass** man ein Keramik-Substrat verwendet, das auf mindestens einer Oberfläche eine Kupfer-Metallisierung aufweist.

6. Verfahren nach mindestens einem der vorangehenden Ansprüche, **dadurch gekennzeichnet, dass** man ein Keramik-Substrat verwendet, das auf mindestens einer Oberfläche eine Aluminium-Metallisierüng aufweist.

7. Verfahren nach mindestens einem der vorangehenden Ansprüche, **dadurch gekennzeichnet, dass** man die Oberfläche des resultierenden Metall-Keramik-Moduls zumindest teilweise mit Nickel, Gold, Silber und/oder einem Schichtsystem dieser Materialien beschichtet.

8. Verfahren nach mindestens einem der vorangehenden Ansprüche, **dadurch gekennzeichnet, dass** man einen Metallkörper verwendet, der Aluminium umfasst.

9. Verfahren nach mindestens einem der vorangehenden Ansprüche, **dadurch gekennzeichnet, dass** eine Keramik verwendet, die Aluminiumoxid, Siliziumnitrid und/oder Aluminiumnitrid umfasst.

10. Verfahren nach mindestens einem der vorangehenden Ansprüche, **dadurch gekennzeichnet, dass** man einen Metallkörper verwendet, der AlSiC, MoCu, WCu, CuMoCu und/oder Cu/Invar/Cu umfasst.

11. Modul, umfassend ein Metall-Keramik-Substrat und einen Metallkörper sowie eine Fügestelle, die das Keramik-Substrat mit dem Metallkörper verbindet und die eine Metalllegierung umfasst, wobei das Metall-Keramik-Substrat mindestens einseitig eine Metallisierung mit einer Dicke kleiner als 1.000,0 µm zum Aufbringen einer schaltungstechnischen Struktur aufweist, die dem Metallkörper zugewandte Seite des Metall-Keramik-Substrats kleiner als die dem Metall-Keramik-Substrat zugewandte Seite des Metallkörpers ist und das Metall-Keramik-Substrat mit dem Metallkörper derart verbunden ist, dass das Metall-Keramik-Substrat auf der dem Metallkörper abgewandten Seite eine Metallisierung umfasst,
**dadurch gekennzeichnet, dass** der Metallkörper eine Dicke kleiner 1 mm aufweist, die Metalllegierung Aluminium enthält und eine Liquidustemperatur größer 450°C aufweist.

12. Modul nach Anspruch 11, **dadurch gekennzeichnet, dass** die benötigte Abschälkraft zum Trennen von Keramik-Substrat und Metallkörper größer 3 N/mm ist.

13. Verwendung eines Moduls nach Anspruch 11 oder 12 als Schaltungsträger in elektronischen Geräten.

## Claims

1. Method for producing a module as a circuit carrier for a circuit structure comprising the following method steps:
joining a metal-ceramic substrate to a metal body by means of a metal alloy, where the metal-ceramic substrate has metallization on at least one side for applying the circuit structure, the metallisation having a thickness less than 1.000,0 µm, and the side of the metal-ceramic substrate facing the metal body being smaller than the side of the metal body facing the metal-ceramic substrate, and the metal-ceramic substrate is joined to the metal body such that the metal-ceramic substrate includes a metallisation on the side facing away from the metal body,
**characterized in that**
a) a metal body having a thickness of less than 1 mm is used,
b) a metal alloy which
b-1) contains aluminium and
b-2) has a liquidus temperature of greater than 450°C is arranged between the metal-ceramic substrate and the metal body,
c) the arrangement from step b) is heated to a temperature of greater than 450°C.

2. Method according to Claim 1, **characterized in that** an alloy which additionally contains silicon is used.

3. Method according to Claim 1, **characterized in that** an alloy which additionally contains magnesium is used.

4. Method according to at least one of the preceding claims, **characterized in that** an alloy containing more than 50.0% by weight of aluminium, based on the total weight of the alloy, is used.

5. Method according to at least one of the preceding claims, **characterized in that** a ceramic substrate which has copper metallization on at least one surface is used.

6. Method according to at least one of the preceding claims, **characterized in that** a ceramic substrate which has aluminium metallization on at least one surface is used.

7. Method according to at least one of the preceding claims, **characterized in that** the surface of the resulting metal-ceramic module is at least partly coated with nickel, gold, silver and/or a layer system composed of these materials.

8. Method according to at least one of the preceding claims, **characterized in that** a metal body comprising aluminium is used.

9. Method according to at least one of the preceding claims, **characterized in that** a ceramic comprising aluminium oxide, silicon nitride and/or aluminium nitride is used.

10. Method according to at least one of the preceding claims, **characterized in that** a metal body comprising AlSiC, MoCu, WCu, CuMoCu and/or Cu/Invar/Cu is used.

11. Module comprising a metal-ceramic substrate and a metal body and also a join which joins the ceramic substrate to the metal body and comprises a metal alloy, where the metal-ceramic substrate has a metallization on at least one side for applying a circuit structure, the metallisation having a thickness less than 1.000,0 µm, and the side of the metal-ceramic substrate facing the metal body being smaller than the side of the metal body facing the metal-ceramic substrate, and the metal-ceramic substrate is joined to the metal body such that the metal-ceramic substrate includes a metallisation on the side facing away from the metal body,
**characterized in that** the metal body has a thickness of less than 1 mm, the metal alloy contains aluminium and has a liquidus temperature of greater than 450°C.

12. Module according to Claim 11, **characterized in that** the peeling force required for separating ceramic substrate and metal body is greater than 3 N/mm.

13. Use of a module according to Claim 11 or 12 as circuit carrier in electronic appliances.

## Revendications

1. Procédé de préparation d'un module en tant que support de circuit pour une structure de circuit avec les étapes de procédé suivantes :
liaison d'un substrat métal-céramique à un corps métallique au moyen d'un alliage métallique, le substrat métal-céramique présentant au moins d'un côté une métallisation d'une épaisseur inférieure à 1000,0 µm pour l'application de la structure de circuit, et le côté du substrat métal-céramique tourné vers le corps métallique étant plus petit que le côté du corps métallique tourné vers le substrat métal-céramique, et le substrat métal-céramique étant relié au corps métallique de telle sorte que le substrat métal-céramique comprend sur le côté opposé au corps métallique une métallisation,
**caractérisé en ce que**
a) un corps métallique d'une épaisseur inférieure à 1 mm est utilisé,
b) un alliage métallique est agencé entre le substrat métal-céramique et le corps métallique, qui
b-1) contient de l'aluminium et
b-2) présente une température de liquidus supérieure à 450 °C,
c) l'agencement de l'étape b) est chauffé à une température supérieure à 450 °C.

2. Procédé selon la revendication 1, **caractérisé en ce qu'**on utilise un alliage qui contient en outre du silicium.

3. Procédé selon la revendication 1, **caractérisé en ce qu'**on utilise un alliage qui contient en outre du magnésium.

4. Procédé selon au moins une des revendications précédentes, **caractérisé en ce qu'**on utilise un alliage qui contient plus de 50,0 % en poids d'aluminium, par rapport au poids total de l'alliage.

5. Procédé selon au moins une des revendications précédentes, **caractérisé en ce qu'**on utilise un substrat céramique qui présente sur au moins une surface une métallisation de cuivre.

6. Procédé selon au moins une des revendications précédentes, **caractérisé en ce qu'**on utilise un substrat céramique qui présente sur au moins une surface une métallisation d'aluminium.

7. Procédé selon au moins une des revendications précédentes, **caractérisé en ce que** la surface du module métal-céramique résultant est revêtue au moins en partie de nickel, d'or, d'argent et/ou d'un système de couches de ces matériaux.

8. Procédé selon au moins une des revendications précédentes, **caractérisé en ce qu'**on utilise un corps métallique qui comprend de l'aluminium.

9. Procédé selon au moins une des revendications précédentes, **caractérisé en ce qu'**on utilise une céramique qui comprend de l'oxyde d'aluminium, du nitrure de silicium et/ou du nitrure d'aluminium.

10. Procédé selon au moins une des revendications précédentes, **caractérisé en ce qu'**on utilise un corps métallique, qui comprend AlSiC, MoCu, WCu, CuMoCu et/ou Cu/invar/Cu.

11. Module, comprenant un substrat métal-céramique et un corps métallique ainsi qu'un assemblage de jonction, qui relie le substrat céramique au corps métallique et qui comprend un alliage métallique, dans lequel le substrat métal-céramique présente au moins d'un côté une métallisation d'une épaisseur inférieure à 1000,0 µm pour l'application d'une structure de circuit, le côté du substrat métal-céramique tourné vers le corps métallique est plus petit que le côté du corps métallique tourné vers le substrat métal-céramique et le substrat métal-céramique est relié au corps métallique de telle sorte que le substrat métal-céramique comprend sur un côté opposé au corps métallique une métallisation,
**caractérisé en ce que** le corps métallique présente une épaisseur inférieure à 1 mm, l'alliage métallique contient de l'aluminium et présente une température de liquidus supérieure à 450 °C.

12. Module selon la revendication 11, **caractérisé en ce que** la force de pelage nécessaire pour la séparation du substrat céramique et du corps métallique est supérieure à 3 N/mm.

13. Utilisation d'un module selon la revendication 11 ou 12 en tant que support de circuit dans des appareils électroniques.
